(19) Europäisches Patentamt
European Patent Office
Office européen des brevets

(11) **EP 1 982 410 B1**

(12) **EUROPEAN PATENT SPECIFICATION**

(45) Date of publication and mention
of the grant of the patent:
**04.12.2019 Bulletin 2019/49**

(51) Int Cl.:
*H03B 5/12* *(2006.01)*          *H03L 7/099* *(2006.01)*

(21) Application number: **07704189.5**

(22) Date of filing: **29.01.2007**

(86) International application number:
**PCT/EP2007/050830**

(87) International publication number:
**WO 2007/090753 (16.08.2007 Gazette 2007/33)**

(54) **OSCILLATOR GAIN EQUALIZATION**

OSZILLATORVERSTÄRKUNGSENTZERRUNG

EGALISATION DU GAIN D'UN OSCILLATEUR

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.02.2006 US 350774**

(43) Date of publication of application:
**22.10.2008 Bulletin 2008/43**

(73) Proprietor: **Telefonaktiebolaget LM Ericsson (publ)**
**164 83 Stockholm (SE)**

(72) Inventor: **STRANDBERG, Roland**
**217 41 Mälmo (SE)**

(74) Representative: **Ericsson**
**Patent Development**
**Torshamnsgatan 21-23**
**164 80 Stockholm (SE)**

(56) References cited:
**DE-A1- 10 312 436          US-A1- 2002 014 925**
**US-A1- 2004 150 485          US-A1- 2005 275 478**

**Description**

TECHNICAL FIELD

The present invention relates to oscillators, more particularly to methods and apparatuses for controlling oscillator gain, and also to methods and apparatuses for controlling oscillator gain to compensate for variations in gain attributed to other components of a circuit such as a phase-locked loop.

BACKGROUND

Radio communication using a wide frequency bandwidth is found in present and upcoming standards, such as Digital Video Broadcasting for Hand-held devices (DVB-H). The need for accommodating a wide frequency bandwidth can also arise when a radio unit is designed to support several standards (e.g., GSM, EDGE, W-CDMA), requiring it to have multi-band capability. Furthermore, the frequency standard for a given standard (e.g., GSM) can differ between countries, thereby requiring a mobile phone intended for a worldwide market to have the same multi-band capability as when several standards are covered. The large frequency bandwidth, relative to the center frequency, requires broadband radio solutions.

A frequency synthesizer is the part of a transceiver that generates signals having the required range of frequencies. The frequency synthesizer is usually designed as a phase-locked loop (PLL), which is a closed-loop system in which the phase of an output signal (or a signal derived from the output signal) is compared with the phase of a reference input signal. The difference between these phase values is used to generate one or more signals that control the output frequency of a controllable oscillator.

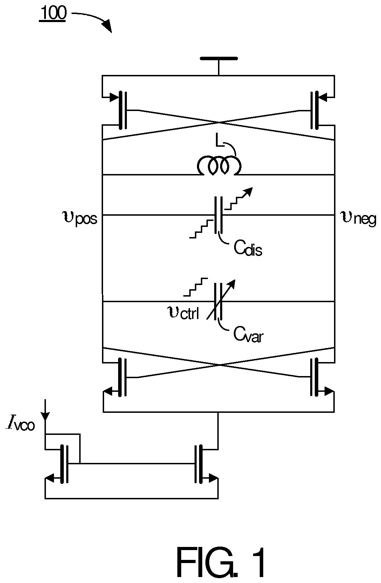

The controllable oscillator is usually implemented either as: 1) an LC oscillator, or 2) a ring oscillator. The complementary LC oscillator is usually chosen in favor of the ring oscillator due to better phase-noise performance for a given level of power consumption. The complementary LC oscillator 100, an exemplary embodiment of which is illustrated in FIG. 1, plays an important role in radio circuit design for its good phase noise, low voltage operation, ease of implementation, and differential operation.

Existing implementations of the complementary LC oscillator 100 are associated with problems, however. The frequency of the LC oscillator 100 is determined by $f = \dfrac{1}{2\pi\sqrt{LC}}$, where L is the inductance and C the capacitance of the resonator. In order to change the frequency, at least one of the values of $L$ and $C$ has to change. Changing the inductance is difficult because the amount of inductance is strongly coupled to the geometry of the inductor. Experiments to change the inductance by switching inductors, or in other ways change the geometry, have been reported in the published literature. Loss of Q-value of the inductor and/or area inefficiency is often associated with this technique. In any case, the granularity of the change in inductance is too coarse to replace the need for changing the capacitance.

An established and accepted technique is to change the capacitance by means of a discrete switchable capacitor part. The discrete switchable capacitor part, illustrated by $C_{dis}$ in FIG. 1, is used for coarse tuning of the frequency and is made up of an array of fixed-size capacitors controlled by a digital word. The length of the digital word together with the bandwidth of the PLL set the minimum gain of the oscillator.

The coarse tuning of the oscillator frequency is achieved by applying a specific digital word to the discrete switchable capacitor part. Following the coarse tuning, fine tuning is performed to precisely get the desired frequency. Fine tuning is conventionally performed by changing a tuning control signal, $v_{ctrl}$, to a varactor which, in FIG. 1, is illustrated by $C_{var}$. In an analog PLL, the oscillator is tunable within a continuous range, normally by means of a single varactor, diode or equivalent. To keep phase-noise low, a small varactor $C_{var}$ is desired. The minimum size of the varactor $C_{var}$ is determined by the bandwidth of the subbands created by the introduction of the discrete switchable capacitor part $C_{dis}$. Problems with a single varactor $C_{var}$ are encountered when both the oscillator gain versus frequency requirement and the required sensitivity to pushing are to be met in broadband frequency synthesizers.

The gain of a voltage controlled oscillator, $H_{VCO}$, is to a first order approximation, proportional to the cube of the frequency. A short derivation of this relation is as follows:

$$\omega = 2\pi f$$

$$\omega = \frac{1}{\sqrt{LC}}$$

$$H_{VCO} \sim \frac{\Delta\omega}{\Delta V_{ctrl}}$$

$$\Delta V_{ctrl} \sim \Delta C$$

$$\frac{\partial\omega}{\partial C} = \frac{\partial\left(LC\right)^{-1/2}}{\partial C} = -\frac{L}{2}\left(\frac{1}{\sqrt{LC}}\right)^{3}$$

This means that there will be large oscillator gain variation if the frequency band is large. Large oscillator gain variation is harmful because it alters the stability, bandwidth, and phase noise of the PLL.

The pushing parameter represents the transfer from the voltage supply to the output frequency. This means that noise on the supply lines will appear as (shaped) phase noise at the output of the oscillator. Predominantly, problems associated with a high pushing figure occur at high frequencies because, at these frequencies, little or no capacitance is connected in parallel with the varactor. This gives the varactor $C_{var}$ large impact on this figure. Since the varactor $C_{var}$ is a voltage controlled capacitor with nonlinear characteristics, its effective capacitance changes as the voltage swing changes (i.e., as the supply voltage is altered).

US 2003/0231068 A1 discloses compensating for tuning gain variations in a PLL by estimating the tuning gain of the oscillator and then adjusting the charge pump current value by a ratio of the nominal tuning gain to the measured tuning gain. US 2004/0263272 A1 similarly discloses adjusting the gain of a charge-pump based on the gain of the VCO so that the over-all gain of the arrangement is maintained in a desired range. Such techniques fail to utilize the VCO itself, however, to improve the overall performance.

US 2005/275478 discloses a voltage controlled oscillator comprising a parallel resonance circuit and a frequency tuning sensitivity control section. The frequency control section shifts a band of an oscillation frequency by controlling ON/OFF of a switching element included in the high-frequency switch circuit. The frequency tuning sensitivity control section adjusts a change rate of a total capacitance of the variable capacitance circuit with respect to a control voltage, depending on a band to be used.

It is therefore desirable to provide an oscillator that reduces the effects of the above-described and other problems.

## SUMMARY

It should be emphasized that the terms "comprises" and "comprising", when used in this specification, are taken to specify the presence of stated features, integers, steps or components; but the use of these terms does not preclude the presence or addition of one or more other features, integers, steps, components or groups thereof.

In accordance with one aspect of the present invention, the foregoing and other objects are achieved in a controlled oscillator comprising a switchable variable capacitor arrangement for tuning an output frequency of the controlled oscillator; and circuitry that, in combination with the switchable variable capacitor arrangement, generates an oscillating signal whose frequency is, at least in part, a function of a total capacitance of the switchable variable capacitor arrangement. The switchable variable capacitor arrangement comprises: a plurality of variable capacitors, each tunable by means of a tuning control signal; and a switch arrangement that selectively opens or closes electrical paths to one or more of the variable capacitors under the control of one or more switch control signals, wherein the number of variable capacitors that contribute to the total capacitance of the switchable variable capacitor arrangement is controlled by states of the one or more switch control signals.

In some embodiments, each of one or more of the variable capacitors is arranged in series with a corresponding one of a number of switches in the switching arrangement, whereby the variable capacitor does not contribute to the total capacitance of the switchable variable capacitor arrangement when the corresponding switch is open, and the variable capacitor does contribute to the total capacitance of the switchable variable capacitor arrangement when the corresponding switch is closed.

In some embodiments, each of the switches comprises a first switch and a second switch; the first switch is arranged to prevent DC bias current from flowing into the tuning control signal when a corresponding one of the variable capacitors is switched into the switchable variable capacitor arrangement; and the second switch is arranged to prevent the corresponding variable capacitor from having an electrical potential that is floating when the corresponding variable capacitor is switched out of the switchable variable capacitor arrangement.

The variable capacitors may be varactors. Further, the switchable variable capacitor arrangement can, for example, be implemented by means of Complementary Metal Oxide Semiconductor (CMOS) technology.

In another aspect, a size of at least one of the variable capacitors is different from a size of at least another one of the variable capacitors.

In still another aspect, the controlled oscillator is part of a phase-locked loop that also includes logic configured to generate a signal that is indicative of a phase difference between a reference signal and a feedback signal, wherein a frequency of the feedback signal is derived from a frequency of a phase-locked loop output signal.

In another aspect, the phase-locked loop includes switch control circuitry for generating the one or more switch control signals as a function of a desired operating frequency so as to achieve a total variable capacitance that reduces loop gain variation of the phase-locked loop.

In yet another aspect, the phase-locked loop includes switch control circuitry for generating the one or more switch control signals as a function of a desired operating frequency, wherein the switch control circuitry switches a different number of the variable capacitors into the switchable variable capacitor arrangement for a different desired operating frequency such that the gain variation of the controlled oscillator over an entire frequency band is reduced.

In some embodiments, the phase-locked loop comprises a frequency divider that generates the feedback signal by dividing a frequency of the controlled oscillator output signal by a predetermined amount. The switch control circuitry in such embodiments can generate the one or more switch control signals so as to open and close appropriate sets of switches within the switch arrangement so as to produce a desired controlled oscillator gain, $H_{CO}$, that will counteract variations in $H_{FD}$, such that the overall variation of the gain product $H_{CO}H_{FD}$ is reduced in a predefined frequency range, wherein $H_{FD}$ is a transfer function of the frequency divider.

In some other embodiments, the phase-locked loop comprises a prescaler that divides a frequency of the controlled oscillator output signal by a predetermined amount; and a frequency divider that generates the feedback signal by dividing a frequency of the controlled oscillator output signal by a predetermined amount. The switch control circuitry in such embodiments can generate the one or more switch control signals so as to open and close appropriate sets of switches within the switch arrangement so as to produce a desired controlled oscillator gain, $H_{CO}$, that will counteract variations in $H_{PS}H_{FD}$, such that the overall variation of the gain product $H_{CO}H_{PS}H_{FD}$ is reduced in a predefined frequency range, wherein $H_{PS}$ is a transfer function of the prescaler and $H_{FD}$ is a transfer function of the frequency divider.

In some embodiments, the one or more switch control signals are generated by a binary-to-thermometer decoder.

BRIEF DESCRIPTION OF THE DRAWINGS

The objects and advantages of the invention will be understood by reading the following detailed description in conjunction with the drawings in which:

FIG. 1 is a schematic diagram of a complementary LC oscillator.

FIG. 2A illustrates an exemplary switchable variable capacitor arrangement.

FIG. 2B illustrates an arrangement including a binary-to-thermometer decoder for generating switch control signals.

FIG. 3 illustrates a phase-domain model of a PLL.

FIG. 4 is a graph representing the variation of $H_{FD}$ over the DVB-H band of 470 MHz - 860 MHz.

FIG. 5 depicts graphs representing exemplary embodiments of an ideal and an actual transfer function of the VCO gain over the DVB-H frequency band in accordance with an aspect of the invention.

FIG. 6 presents a graph 601 depicting the variation of the gain product $H_{VCO}H_{PS}H_{FD}$ in accordance with a conventional, single varactor arrangement, and a graph 603 depicting the variation of the gain product $H_{VCO}H_{PS}H_{FD}$ achievable in accordance with an exemplary embodiment of the invention, utilizing the switchable variable capacitor arrangement described earlier.

FIG. 7A is a schematic diagram of an exemplary implementation of one switch/variable capacitor portion of the switchable variable capacitor arrangement 200 in FIG. 2A for differential signals, in which ideal components are used.

FIG. 7B is a schematic diagram of a circuit for generating complementary control signals for controlling the exemplary implementation of the switch/variable capacitor portion of the switchable capacitor.

FIG. 8 illustrates an exemplary embodiment of the schematic of FIG. 7A utilizing CMOS technology.

FIG. 9 is a block diagram of a PLL that incorporates various aspects of the invention.

DETAILED DESCRIPTION

The various features of the invention will now be described with reference to the figures, in which like parts are identified with the same reference characters.

The various aspects of the invention will now be described in greater detail in connection with a number of exemplary embodiments. To facilitate an understanding of the invention, many aspects of the invention are described in terms of sequences of actions to be performed by elements of a computer system or other hardware capable of executing programmed instructions. It will be recognized that in each of the embodiments, the various actions could be performed by specialized circuits (e.g., discrete logic gates interconnected to perform a specialized function), by program instructions being executed by one or more processors, or by a combination of both. Moreover, the invention can additionally be considered to be embodied entirely within any form of computer readable carrier, such as solid-state memory, magnetic disk, optical disk or carrier wave (such as radio frequency, audio frequency or optical frequency carrier waves) containing an appropriate set of computer instructions that would cause a processor to carry out the techniques described herein. Thus, the various aspects of the invention may be embodied in many different forms, and all such forms are contemplated to be within the scope of the invention. For each of the various aspects of the invention, any such form of embodiments may be referred to herein as "logic configured to" perform a described action, or alternatively as "logic that" performs a described action.

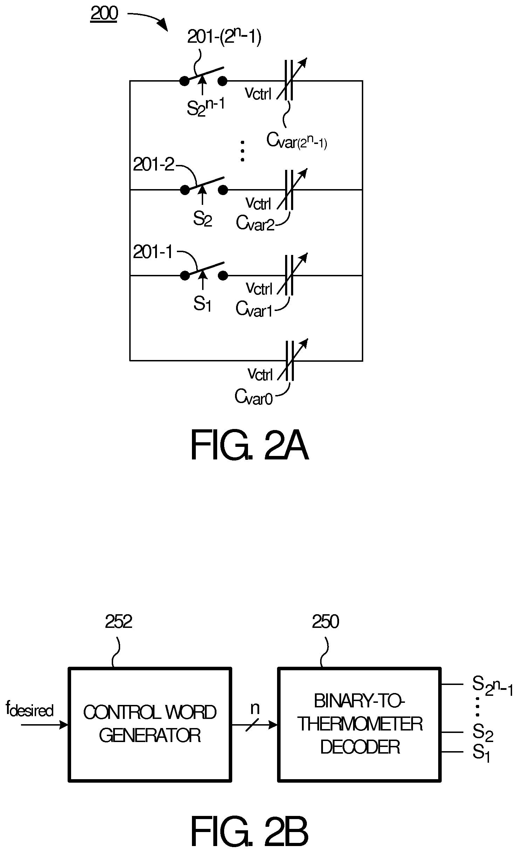

In one aspect of embodiments consistent with the invention, the continuously variable capacitor (i.e., the varactor, $C_{var}$) normally used in the LC circuit 100 is replaced by an arrangement whose capacitance is programmable by means of an applied digital word. An exemplary switchable variable capacitor arrangement 200 is shown in FIG. 2A. As illustrated, each of a number (e.g., $2^n - 1$ where $n \geq 1$) of variable capacitors (e.g., varactors $C_{var1}...C_{var(2^n-1)}$) is arranged in series with a corresponding one of a like number of switches 201-1 ... 201-($2^n$-1). These switch/variable capacitor combinations are connected in parallel with a non-switchable variable capacitor $C_{var0}$, so that by selectively opening and closing different ones of the switches 201-1 ... 201-($2^n$-1), different ones and/or numbers of the variable capacitors are effectively arranged in parallel with one another. A primary reason for using this overall arrangement is to get a better leveled oscillator gain across the frequency band. In addition, sensitivity to pushing is reduced, especially at the high end of the frequency band, because smaller-sized varactors can be used compared to conventional single-varactor implementations. Each of the varactors $C_{var0}...C_{var(2^n-1)}$ is continuously controlled by a signal, $v_{ctrl}$, and a digital word is used to switch in an appropriate number of varactors (depending on the output frequency). For enhanced control of the accumulated size of the varactor, a binary-to-thermometer decoder 250, as illustrated in FIG. 2B, is preferably used to generate the switch control signals $s_1...s_{2_n-1}$. An exemplary transfer function of a binary-to-thermometer in which $n = 3$ is shown in Table 1, below.

Table 1: 3-bit binary-to-thermometer decoder

| Binary $b_2b_1b_0$ | Thermometer $s_7s_6s_5s_4s_3s_2s_1$ |
| --- | --- |
| 000 | 0000000 |
| 001 | 0000001 |
| 010 | 0000011 |
| 011 | 0000111 |
| 100 | 0001111 |
| 101 | 0011111 |
| 110 | 0111111 |
| 111 | 1111111 |

The binary-to thermometer decoder is conventionally useful for converting a binary number into control signals for selectively activating segments of a digital readout. The higher the supplied binary number, the more segments are activated. As can be seen in this example, each of the output signals is activated if its significance within the output word (i.e., the numeric value of the subscript x for each output bit $s_x$) is less than or equal to the supplied binary value, so long as the supplied binary value is not equal to zero. When the control signals are used to switch in or out selected ones of the varactors $C_{var0}...C_{var(2^n-1)}$, all varactors will be connected in parallel for the lowest frequency generated.

The binary-to-thermometer decoder 250 is advantageous in two ways:

1) The function that relates the change of the accumulated size of the varactors to the change in binary value (interpreted as a decimal value) can be made arbitrary.
2) It is much easier to get a monotonic function when using the binary-to-thermometer decoder 250, especially in the presence of parasitic capacitance that will appear in every implementation of the circuitry. The monotonic behavior is very important because without it, the closed-loop system (here the PLL) can end up in a limit cycle (i.e., a steady state solution in which the control signal is undesirably in a stable oscillation).

In embodiments that utilize a binary-to-thermometer decoder 250, the number of varactors needed is $2^n$, where $n$ is the word length of the binary word. A large value of $n$ requires many varactors. For $n$ larger than say 3 or 4, embodiments can employ the binary-to-thermometer decoder 250 to decode at least the least significant bits of the supplied binary control word, whereas the other bits are retained in their binary form. This results in a reduced number of required varactors, and at the same time makes it easier to accomplish the monotonic function discussed above.

The $n$-bit binary control word supplied to the binary-to-thermometer decoder 250 is generated by a control word generator 252 whose input is a signal representing the desired (or demanded) output frequency, $f_{desired}$. The control word generator 252 can be implemented as, for example, a look-up table (LUT) whose contents are stored at addresses such that frequencies within a certain region will generate a specific output control word.

The VCO gain characteristic is usually found either from simulations or from measurements. Based on this information, the break point of when to switch in or out a varactor is determined such that the concatenated VCO gain variation will be minimized in a min-max sense relative to the ideal transfer function.

In some embodiments, all parts of the variable capacitor arrangement 200 are connected in parallel at low output frequencies, whereas at high frequencies only one is connected. Different numbers of the varactors $C_{var0}...C_{var(2^n-1)}$ are switched in for operation at the frequencies in-between the low and high extremes. The size of the varactor part that is always connected (e.g., $C_{var0}$ in the exemplary embodiment) is selected such that the continuous tuning covers at least one sub-band (set by a discrete switchable capacitor part, $C_{dis}$, comparable to that shown in FIG. 1) plus a design margin. At low frequencies when all parts of the variable capacitor arrangement 200 are switched in, the oscillator gain dictates the size of the varactor sum. This is described further in the discussion below. The partitioning of the variable capacitance between the individual varactors for optimum performance is preferably done by choosing the individual size of the varactor $C_x$ ($0 \leq x \leq 2^n -1$) such that it counteracts the $1/2\pi\sqrt{LC}$ frequency relation of the oscillator. Normally, a few iterations are enough to find a near optimum sizing of the varactor parts. This is also further explained below.

The above and other aspects are now described in greater detail. Looking first at the oscillator gain, it is part of the loop gain of the PLL. It is important that the loop gain be well controlled in a way that will guarantee the stability and bandwidth of the PLL. The loop gain can be derived from the phase-domain model, which will be described shortly. The ideal oscillator gain is found from the transfer functions in the phase-domain model. The actual oscillator gain is then mapped to the ideal curve by changing the size of the capacitance in a switchable manner.

To illustrate the strengths of the methods and apparatuses presented herein, exemplary embodiments will now be described that apply the inventive techniques in a DVB-H frequency synthesizer with certain word lengths controlling the capacitance of a voltage controlled oscillator (VCO). Of course, alternative embodiments can use different size word lengths and be applicable to other standards as well.

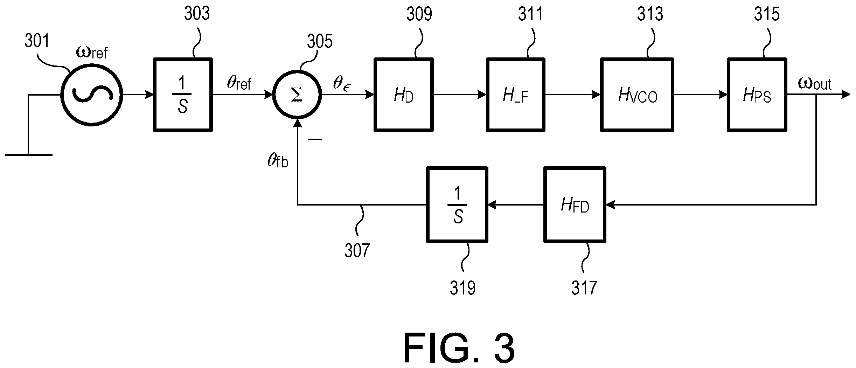

FIG. 3 illustrates a phase-domain model of a PLL. The PLL is modeled in the phase-domain to catch the dynamics of the system in the vicinity of the steady-state operating point. A reference oscillator 301 generates a reference frequency $\omega_{ref}$ that serves as the input signal to the system. The PLL's output frequency, $\omega_{out}$, is generated relative to the reference frequency.

A first integrator 303 generates a reference phase signal, $\theta_{ref}$, and supplies this to a phase comparator 305. A phase error $\theta_\varepsilon = \theta_{ref} - \theta_{fb}$ generated by the phase comparator 305 contains the discrepancy between the phase of the reference ($\theta_{ref}$) and the phase ($\theta_{fb}$) of the feedback signal 307. The phase error is the input to a phase detector, which generates the control signal to a charge pump. For purposes of the model, it is convenient to merge the phase detector and charge pump into a single detector, $H_D$ 309. The output current from the detector 309 is filtered and transformed into a corresponding control voltage level by the loop filter 311 ($H_{LF}$). The loop filter 311 is used to set the stability and the closed-loop bandwidth of the PLL.

The control voltage from the loop filter 311 controls the VCO 313 ($H_{VCO}$), which generates an oscillating signal whose frequency is controlled by the control voltage. In this exemplary embodiment, this frequency is divided by 2 in a fixed-modulus divider (hereinafter the prescaler 315 , $H_{PS}$) to generate in-phase and quadrature phase (I and Q, respectively) output signals. It will be understood, however, that the prescaler 315 is optional. However, in most cases a prescaler 315 is used to generate the quadrature phase output signals. These signals are only visible in the phase-domain model if a complex notation is used. The output frequency of the PLL, $\omega_{out}$, is fed back to a multiple-modulus divider (hereinafter the frequency divider 317, $H_{FD}$). The divisor used by the frequency divider 317 is programmable to generate the desired output frequency. Again, since the phase is compared at the input of the phase comparator 305, a second integrator 319 integrates the frequency divided feedback signal to generate the phase signal, $\theta_{fb}$.

The system level definitions of the transfer functions are given as follows:

$H_D$: The transfer function of the phase-frequency detector (PFD) and the charge pump (CHP), which are treated as one unit -- the detector 309. Unit: (A/rad).

$H_{LF}$: The transfer function of the loop filter 311. Unit: (V/A).

$H_{VCO}$: The gain of the VCO 313. Unit: (rad/(V·s)).

$H_{PS}$: The transfer function of the prescaler 315, which is treated as an attenuation equal to the division number. Unit: (dimensionless).

$H_{FD}$: The transfer function of the frequency divider, which is treated as an attenuation equal to the division number. Unit: (dimensionless).

$\dfrac{1}{s}$: Representation of an integration using the Laplace variable, s. Unit: (s).

The loop gain for the system in FIG. 3 is given by:

$$\beta \quad = \frac{\theta_\in}{\omega_{out}}\bigg|_{\omega_{ref}=0} = -\frac{H_{FD}}{s}$$

$$A \quad = \frac{\omega_{out}}{\theta_\in} = H_D H_{LF} H_{VCO} H_{PS} \tag{1}$$

$$A\beta \quad = -\frac{H_D H_{LF} H_{VCO} H_{PS} H_{FD}}{s}$$

The asymptotic transfer function, $A_{t\infty}$, is given by:

$$A_{t\infty} = \frac{\omega_{out}}{\omega_{ref}}\bigg|_{A\beta=\infty} = \frac{1}{H_{FD}}. \tag{2}$$

The closed-loop transfer function, $A_t$, is given by:

$$A_t = \frac{\omega_{out}}{\omega_{ref}} = A_{t\infty}\frac{-A\beta}{1-A\beta}. \tag{3}$$

The actual implementation of the PLL results in non-ideal transfer functions. The variation in the transfer function of the VCO 313, the prescaler 315, and the frequency divider 317 are finally compensated by controlling the charge pump current. The goal is to make the product of these transfer functions constant across the whole frequency band.

The transfer function of the frequency divider is $H_{FD} = 1/N$, where N is the divisor. In Eqn (2), it was shown that the asymptotic transfer function, $A_{t\infty} = 1/H_{FD}$. This means that the divisor is given by:

$$N = \frac{\omega_{out}}{\omega_{ref}}. \tag{4}$$

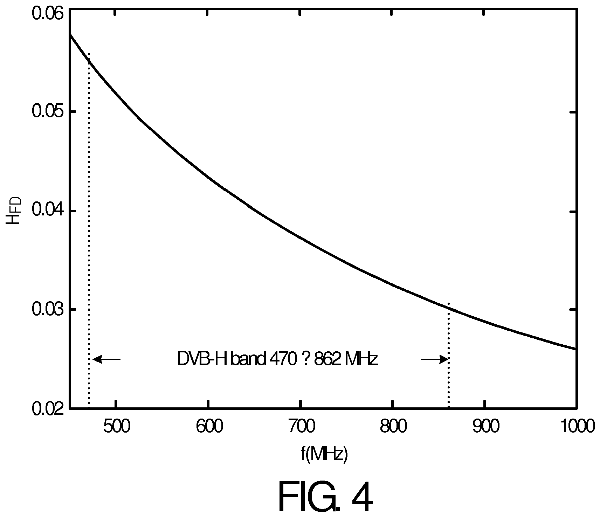

To cover the DVB-H frequency band (470 MHz - 860 MHz) with a 26 MHz reference frequency, $N$ = 18.1 should be used at the lower end of the frequency band, and N = 33.1 should be used at the upper end. The variation in $H_{FD}$ is 1.83:1, meaning that the gain of the frequency divider 317 at the low frequency edge is 1.83 times larger than at the high frequency edge. A graph representing the variation of $H_{FD}$ over the DVB-H band is illustrated in FIG. 4.

The VCO gain $H_{VCO} \sim f^3$, which means that the VCO gain variation over the frequency band will be large. Theoretically, $H_{VCO}$ will vary in accordance with the ratio of 1:6.2. The variation of the gain product $H_{VCO}H_{PS}H_{FD}$ is actually less, however, because the oscillator gain variation is counteracted by the variation of $H_{FD}$.

Still, there is a need for better controlled oscillator gain. The outcome of the equalization is that the oscillator gain at the lowest frequency band is designed to be around one fourth of the value at the highest frequency band. In the exemplary embodiment, the coarse equalization is accomplished by a switchable size of the varactor. First, the gain of the VCO is selected to achieve small variations of the product $H_{VCO}H_{PS}H_{FD}$ (herein referred to as the "gain product of the VCO and prescaler/frequency divider") across the frequency band. More generically (e.g., because other embodiments may not include, for example, the prescaler), any fully predictable transfer function of the loop gain can be in the product that is equalized with the VCO gain. Second, the charge pump current is selected to minimize the variations of the product $H_D H_{VCO} H_{PS} H_{FD}$. The algorithm for selecting the charge pump current is not discussed here in great detail because it is independent of prior equalization and is performed after the oscillator gain compensation. A summary of how it is performed is as follows:

In addition to the gain equalization already made by selecting $H_{VCO}$, the charge pump current is selected. The algorithm for the charge pump current selection is as follows:

1. Generate $f = H_{VCO} H_{PS} H_{FD}$.
2. Calculate the average value $f_{avg} = (\max(f^1) + \min(f^1))/2$.
3. Normalize, $f_{norm} = f^1/f_{avg}$.
4. Adapt $f_{norm}$ to the selected average charge pump current by first finding $I_{CHPavg} = I_{CHP} / I_{step}$, and then calculating $I_{CHPsel} = \text{round} (I_{CHPavg} f_{norm})$.
5. Limit the output control signal to $I_{CHPsel} \in \{1, 2^b\text{-}1\}$, where $b$ is the number of bits controlling the charge pump current.

Techniques for minimizing the gain product variation of the VCO and prescaler/frequency divider, $H_{VCO} H_{PS} H_{FD}$, will now be discussed in greater detail. After initially minimizing this variation, the detector 309 is used to further reduce the variation of the gain product of the VCO, phase detector and prescaler/frequency divider, $H_D H_{VCO} H_{PS} H_{FD}$. In other words, first the VCO gain is controlled, followed by control of the charge pump current to refine and equalize the gain from these stages.

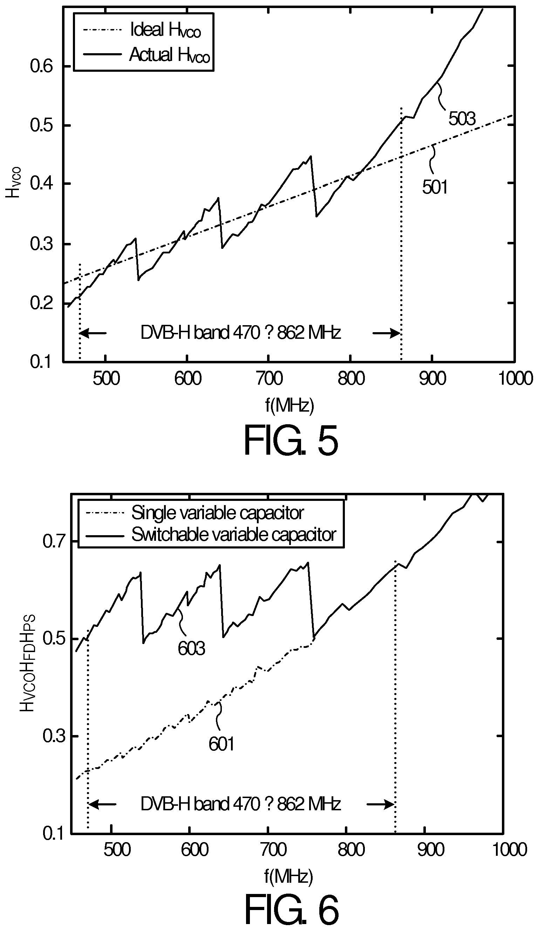

The gain of the prescaler/frequency divider, $H_{PS} H_{FD}$, is fully predictable. The ideal transfer function of the VCO gain to make $H_{VCO} H_{PS} H_{FD}$ constant over the frequency range of interest is $(H_{PS} H_{FD})^{-1}$. The graph 501 in FIG. 5 illustrates this ideal transfer function. The graph 503 illustrates the VCO transfer function that is achievable in accordance with an exemplary embodiment. This transfer function is achieved by selectively switching in suitable varactors in a configuration such as that illustrated in FIG. 2. It can be seen that this results in a piecewise transfer function related to the effective size of the varactor(s). It should be recalled when studying this and other graphs that the main frequency band for DVB-H systems is 470 MHz - 860 MHz, so that it is not necessary to perform varactor switching outside of this range. In this exemplary embodiment, the varactor configuration is controlled by 2 bits (i.e., four distinct varactor configurations are possible). The VCO gain is chosen to approximate the ideal behavior as well as possible by partitioning the size of the individual varactors. In FIG. 5 it can be seen that the ratio between the VCO gain at high and low frequency of the DVB-H band should be approximately 2. More precisely, it is determined by $N_{max}/N_{min} = 1.83$.

FIG. 6 presents a graph 601 depicting the variation of the gain product $H_{VCO} H_{PS} H_{FD}$ in accordance with a conventional, single varactor, arrangement, and a graph 603 depicting the variation of the gain product $H_{VCO} H_{PS} H_{FD}$ achievable in accordance with an exemplary embodiment of the invention, utilizing the switchable variable capacitor arrangement described earlier. The improvements in gain equalization possible with the switchable variable capacitor arrangement is significant. The gain of the oscillator is improved at low frequency by a ratio of 2.3 compared to the conventional employment of a single varactor, and this gives less gain variation over the entire frequency band. The switching points for the switchable variable capacitor arrangement are determined such that the variation of the gain product $H_{VCO} H_{PS} H_{FD}$ is minimized in the frequency range of interest, as can be seen in the sawtooth portion of graph 603. The minimum and maximum value of the gain product $H_{VCO} H_{PS} H_{FD}$ can be located at any position within the frequency band of interest.

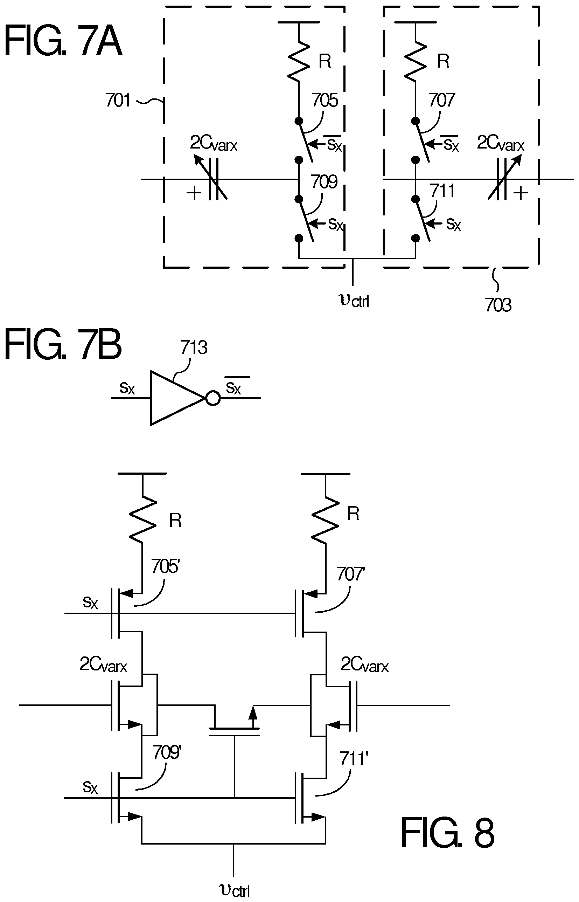

The discussion will now focus on an exemplary varactor implementation of the switchable variable capacitor arrangement 200. FIG. 2 depicts a top-level schematic of the switchable variable capacitor arrangement 200. The switchable variable capacitor arrangement 200 comprises a plurality of elements arranged in parallel, each element effectively comprising a variable capacitor in series with a switch (herein referred to as "switch/variable capacitor element"). As will be seen later, the "switch" may in fact be implemented by an arrangement of switches, and the "variable capacitor" may in fact be implemented by an arrangement of two or more variable capacitors. Each of the switch/variable capacitor elements of the arrangement can be implemented in any of a number of different ways. FIG. 7A is a schematic diagram of one such exemplary implementation of the switch/variable capacitor element of the switchable capacitor arrangement 200 for differential signals, in which ideal components are used. The switch/variable capacitor element is split into two identical parts 701 and 703. These parts are connected such that the varactor part is fully symmetric. When the switch control signal $s_x$ is asserted, each of the capacitors $2C_{varx}$ is switched into the circuit by the closing of the switches 709 and 711, with the voltage $v_{ctrl}$ determining the amount of capacitance that the capacitor $2C_{varx}$ will contribute to the overall arrangement. Asserting $s_x$ also opens up switches 705 and 707, thereby disconnecting the resistors from this part of the circuit. When the switch control signal $s_x$ is de-asserted, the switches 709 and 711 open up, and the switches 705 and 707 close. The opening of switches 705, 707 prevents DC bias current from flowing into $v_{ctrl}$. The resistors $R$ prevent floating nodes in off-mode.

FIG. 7B is a schematic diagram of a circuit for generating the complementary switch control signal $\overline{s_x}$ from the signal $s_x$. The exemplary circuit simply comprises an inverter 713 for inverting the signal, $s_x$.

The circuit of FIG. 7A can be implemented in any number of ways, depending on what technology is chosen. FIG. 8 illustrates an exemplary embodiment of the schematic of FIG. 7A utilizing Complementary Metal Oxide Semiconductor (CMOS) technology. In this case, it is unnecessary to generate complementary control signals $s_x$ and $\overline{s_x}$, because the switches themselves are fabricated from complementary types of transistors such that when transistors 709' and 711' are switched on by the control signal $s_x$, that same control signal $s_x$ switches off the transistors 705' and 707', and vice versa.

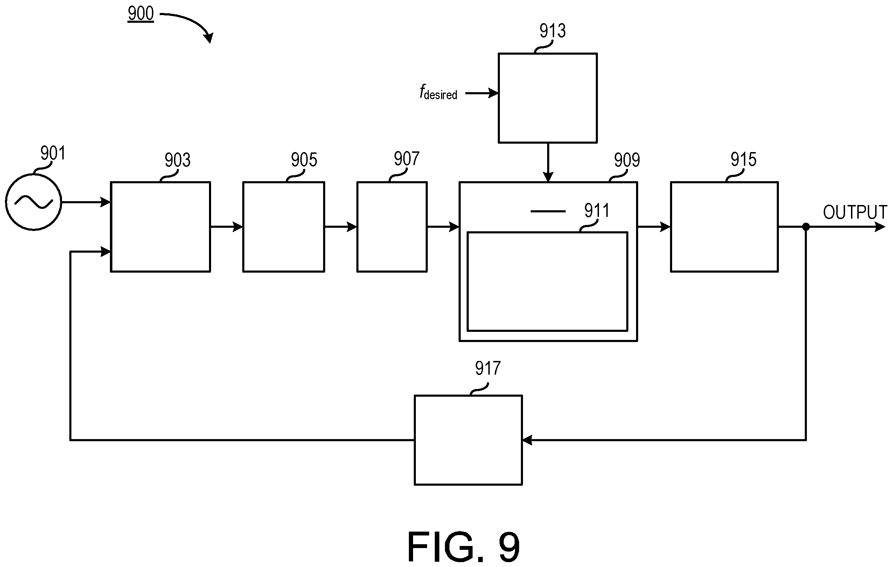

FIG. 9 is a block diagram of a PLL 900 that incorporates various aspects of the invention. A reference oscillator 901 generates a reference signal that is supplied to a first input of a phase difference detector 903. A second input to the phase difference detector 903 receives a feedback signal supplied by a feedback path of the PLL 900 (described further below). The phase difference detector 903 generates a signal representing the phase difference between its two input signals, and supplies this to a charge pump 905. The current supplied by the charge pump 905 is proportional to the phase difference between the reference signal and the feedback signal. This current is converted to a corresponding voltage by a loop filter 907. The voltage generated by the loop filter 907 corresponds to the tuning control signal, $v_{ctrl}$, which was described earlier. This voltage is supplied to a VCO 909 for the purpose of controlling the frequency of the signal generated by the VCO 909.

In this case, the VCO 909 includes a switchable variable capacitor arrangement 911 as described earlier (e.g., see FIG. 2A and supporting text). The switchable variable capacitor arrangement 911 includes a plurality of variable capacitors, each tunable by means of the tuning control signal, $v_{ctrl}$. The switchable variable capacitor arrangement further includes a switch arrangement which, as earlier-described, selectively opens or closes electrical paths to one or more of the variable capacitors under the control of one or more switch control signals, such that the number of variable capacitors that contribute to the total capacitance of the switchable variable capacitor arrangement is controlled by states of the one or more switch control signals. The switchable variable capacitor arrangement 911 in combination with other circuit elements (not shown in FIG. 9, but exemplified by one or more inductors and other transistors such as illustrated in FIG. 1) generate the VCO output signal.

The PLL 900 further includes a switch controller 913 for determining which of the switches in the switchable variable capacitor arrangement 911 will be open, and which will be closed. Based on the desired frequency, $f_{desired}$, the switch controller 913 opens and closes appropriate sets of switches so as to produce a desired VCO gain, $H_{VCO}$, that will counteract variations in $H_{PS}H_{FD}$, such that the overall variation of the gain product $H_{VCO}H_{PS}H_{FD}$ is reduced in a predefined frequency range of interest. In alternative embodiments, the switch controller 913 can receive other signals to obtain equivalent information from which to base switching configurations. More broadly, the VCO gain, $H_{VCO}$, is controlled such that the variation of the loop gain of the closed-loop system is minimized. In practice, the VCO gain depends not only on the size of the variable capacitors, $C_{var0}...C_{var(2^n-1)}$, but also on the control voltage that is used, depending on varactor implementation. Exemplary switching points may be seen in the graph 603 presented in FIG. 6.

The remaining components of the PLL 900 are conventional. A prescaler 915 receives the signal generated by the VCO 909 and divides this by a fixed number, as needed, to generate a PLL output signal having a desired frequency.

The PLL output signal is also supplied to a feedback path that includes a divide-by-N frequency divider 917. The use of such frequency dividers for the purpose of causing the frequency of the PLL output signal to have a particular proportion to the input reference frequency is well-known, and therefore need not be described here in detail. The output of the frequency divider 917 is the feedback signal that is supplied to the second input of the phase difference detector 903, as earlier described.

An oscillator spanning over a wide frequency range benefits from using a switchable variable capacitor arrangement, such as a switchable varactor, because the oscillator gain can be better controlled than if a single variable capacitor (e.g., varactor) is used. By reducing the oscillator gain variation, the stability and the bandwidth of the PLL are easier to control. Also, by reducing the oscillator gain variation, the noise sensitivity at the input of the oscillator shows less variation. This makes the optimization of the noise from the loop filter easier. Often, more noise from the loop filter can be allowed compared to a single varactor implementation for the same phase noise performance at the output of the PLL.

The various embodiments in conformance with the invention enable the use of broadband oscillators with qualities normally found in narrow-band oscillators. The oscillator gain equalization is achieved by piecewise approximation of the ideal transfer function. The switchable varactors add some extra components and lower the Q value of the varactor arrangement. However, by sensible sizing of the switches, the loss in phase-noise performance is made negligible.

The invention has been described with reference to particular embodiments. However, it will be readily apparent to those skilled in the art that it is possible to embody the invention in specific forms other than those of the embodiment described above.

For example, the switchable variable capacitor arrangement has been illustrated above as having switch/variable capacitor elements that are connected in parallel. However, alternative embodiments can easily be derived in which variable capacitors are switchably connected in series with one another rather than in parallel to bring about the desired range in the total capacitance of the switchable variable capacitor arrangement. In yet other alternatives, embodiments can easily be derived in which variable capacitors are switchably connected in an arrangement involving combinations of parallel and series connections.

Also, the above-described embodiments have all involved voltage controlled oscillators. However, it is well known that other oscillators are controllable by something other than voltage, for example, current. The various principles described above are equally applicable to such other types of oscillators. Accordingly, the term "controlled oscillator" is used herein to refer to controllable oscillators, regardless of whether that control is by means of voltage, current, or some other parameter.

Thus, the described embodiments are merely illustrative and should not be considered restrictive in any way. The scope of the invention is given by the appended claims, rather than the preceding description, and all variations and equivalents which fall within the range of the claims are intended to be embraced therein.

## Claims

1.  A phase-locked loop (900) comprising:

    logic (903) configured to generate a signal that is indicative of a phase difference between a reference signal (901) and a feedback signal, wherein a frequency of the feedback signal is derived from a frequency of a phase-locked loop output signal; and
    a controlled oscillator (909) that generates an oscillator output signal having a frequency that is, at least in part, a function of the generated signal,
    wherein the controlled oscillator (909) comprises:

    a switchable variable capacitor arrangement (911) for tuning an output frequency of the controlled oscillator (909); and
    circuitry that, in combination with the switchable variable capacitor arrangement (911), generates an oscillating signal whose frequency is, at least in part, a function of a total capacitance of the switchable variable capacitor arrangement (911);

    wherein the switchable variable capacitor arrangement (911) comprises:

    a plurality of variable capacitors ($C_{var1}...C_{var(2n-1)}$), each tunable by means of a tuning control signal ($v_{ctrl}$); and
    a switch arrangement (201-1 ... 201-($2^n$-1)) that selectively opens or closes electrical paths to one or more of the variable capacitors ($C_{var1}...C_{var(2n-1)}$) under the control of one or more switch control signals ($s_1...s_{2n-1}$), wherein the number of variable capacitors that contribute to the total capacitance of the switchable variable capacitor arrangement (911) is controlled by states of the one or more switch control signals ($s_1...s_{2n-1}$),

    wherein the phase-locked loop (900) further comprises:
    switch control circuitry (913) for generating the one or more switch control signals ($s_1...s_{2n-1}$) as a function of a desired operating frequency so as to achieve a total variable capacitance that reduces loop gain variation of the phase-locked loop (900),
    wherein:
    the phase locked loop (900) comprises:

    a frequency divider (917) that generates the feedback signal by dividing a frequency of the oscillator output signal by a predetermined amount; and
    the switch control circuitry (913) generates the one or more switch control signals ($s_1...s_{2n-1}$) so as to open and close appropriate sets of switches within the switch arrangement (201-1 ... 201-($2^n$-1)) so as to produce a desired controlled oscillator gain, $H_{CO}$, that will counteract variations in $H_{FD}$, such that the overall variation of the gain product $H_{CO}H_{FD}$ is reduced in a predefined frequency range, wherein $H_{FD}$ is a transfer function of the frequency divider (917);
    **characterised in that** the one or more switch control signals ($s_1...s_{2n-1}$) are generated by a binary-to-thermometer decoder (250).

2. The phase-locked loop (900) of claim 1, wherein the switch control circuitry (913) switches a different number of the variable capacitors ($C_{var1}...C_{var(2n-1)}$) into the switchable variable capacitor arrangement (911) for a different desired operating frequency such that the gain variation of the controlled oscillator (909) over an entire frequency band is reduced.

3. A phase-locked loop (900) comprising:

logic (913) configured to generate a signal that is indicative of a phase difference between a reference signal (901) and a feedback signal, wherein a frequency of the feedback signal is derived from a frequency of a phase-locked loop output signal; and
a controlled oscillator (909) that generates an oscillator output signal having a frequency that is, at least in part, a function of the generated signal,
wherein the controlled oscillator (909) comprises:

a switchable variable capacitor arrangement (911) for tuning an output frequency of the controlled oscillator (909); and
circuitry that, in combination with the switchable variable capacitor arrangement (911), generates an oscillating signal whose frequency is, at least in part, a function of a total capacitance of the switchable variable capacitor arrangement (911);

wherein the switchable variable capacitor arrangement (911) comprises:

a plurality of variable capacitors ($C_{var1}...C_{var(2n-1)}$), each tunable by means of a tuning control signal ($v_{ctrl}$); and
a switch arrangement (201-1 ... 201-($2^n$-1)) that selectively opens or closes electrical paths to one or more of the variable capacitors ($C_{var1}...C_{var(2n-1)}$) under the control of one or more switch control signals ($s_1...s_{2n-1}$), wherein the number of variable capacitors ($C_{var1}...C_{var(2n-1)}$) that contribute to the total capacitance of the switchable variable capacitor arrangement (911) is controlled by states of the one or more switch control signals ($s_1...s_{2n-1}$),

wherein the phase-locked loop (900) further comprises:

switch control circuitry (913) for generating the one or more switch control signals ($s_1...s_{2n-1}$) as a function of a desired operating frequency so as to achieve a total variable capacitance that reduces loop gain variation of the phase-locked loop (900),
wherein:

the phase locked loop (900) comprises:

a prescaler (915) that divides a frequency of the oscillator output signal by a predetermined amount to generate a prescaler output signal; and
a frequency divider (917) that generates the feedback signal by dividing a frequency of the prescaler output signal by a predetermined amount; and

the switch control circuitry (913) generates the one or more switch control signals ($s_1...s_{2n-1}$) so as to open and close appropriate sets of switches within the switch arrangement (201-1 ... 201-($2^n$-1)) so as to produce a desired controlled oscillator gain, $H_{CO}$, that will counteract variations in $H_{PS}H_{FD}$, such that the overall variation of the gain product $H_{CO}H_{PS}H_{PD}$ is reduced in a predefined frequency range, wherein $H_{PS}$ is a transfer function of the prescaler (915) and $H_{FD}$ is a transfer function of the frequency divider (917);

**characterised in that** the one or more switch control signals ($s_1...s_{2n-1}$) are generated by a binary-to-thermometer decoder (250).

4. A method of generating an oscillating signal comprising:

generating a signal that is indicative of a phase difference between a reference signal and a feedback signal, wherein a frequency of the feedback signal is derived from a frequency of a phase-locked loop output signal;

using a controlled oscillator (909) to generate an oscillator output signal having a frequency that is, at least in part, a function of the generated signal,

> wherein the controlled oscillator (909) comprises:

>> a switchable variable capacitor arrangement (911) for tuning an output frequency of the controlled oscillator (909); and
>> circuitry that, in combination with the switchable variable capacitor arrangement (911), generates an oscillating signal whose frequency is, at least in part, a function of a total capacitance of the switchable variable capacitor arrangement (911),

> wherein the switchable variable capacitor arrangement (911) comprises:

>> a plurality of variable capacitors ($C_{var1}...C_{var(2n-1)}$), each tunable by means of a tuning control signal ($v_{ctrl}$);
>> a switch arrangement (201-1 ... 201-($2^n$-1)) that selectively opens or closes electrical paths to one or more of the variable capacitors ($C_{var1}...C_{var(2n-1)}$) under the control of one or more switch control signals ($s_i...s_{2,1}$), wherein the number of variable capacitors that contribute to the total capacitance of the switchable variable capacitor arrangement (911) is controlled by states of the one or more switch control signals ($s_1...s_{2n-1}$); and

> generating the one or more switch control signals ($s_1...s_{2n-1}$) as a function of a desired operating frequency so as to achieve a total variable capacitance that reduces loop gain variation of the phase-locked loop (900); and
> using a frequency divider (917) to generate the feedback signal by dividing a frequency of the oscillator output signal by a predetermined amount; and
> generating the one or more switch control signals ($s_1...s_{2n-1}$) so as to open and close appropriate sets of switches within the switch arrangement (201-1 ... 201-($2^n$-1)) so as to produce a desired controlled oscillator gain, $H_{CO}$, that will counteract variations in $H_{FD}$, such that the overall variation of the gain product $H_{CO}H_{FD}$ is reduced in a predefined frequency range, wherein $H_{FD}$ is a transfer function of the frequency divider (917);
> **characterised in that** the one or more switch control signals ($s_1...s_{2n-1}$) are generated by a binary-to-thermometer decoder (250).

5. The method of claim 4, wherein generating the one or more switch control signals ($s_1...s_{2n-1}$) comprises switching a different number of the variable capacitors ($C_{var1}...C_{var(2n-1)}$) into the switchable variable capacitor arrangement (911) for a different desired operating frequency such that the gain variation of the controlled oscillator (909) over an entire frequency band is reduced.

6. A method of generating an oscillating signal comprising:

> generating a signal that is indicative of a phase difference between a reference signal (901) and a feedback signal, wherein a frequency of the feedback signal is derived from a frequency of a phase-locked loop output signal;
> using a controlled oscillator (909) to generate an oscillator output signal having a frequency that is, at least in part, a function of the generated signal,

>> wherein the controlled oscillator (909) comprises:

>>> a switchable variable capacitor arrangement (911) for tuning an output frequency of the controlled oscillator; and
>>> circuitry that, in combination with the switchable variable capacitor arrangement (911), generates an oscillating signal whose frequency is, at least in part, a function of a total capacitance of the switchable variable capacitor arrangement (911),

>> wherein the switchable variable capacitor arrangement (911) comprises:

>>> a plurality of variable capacitors ($C_{var1}...C_{var(2n-1)}$), each tunable by means of a tuning control signal ($v_{ctrl}$);
>>> a switch arrangement (201-1 ... 201-($2^n$-1)) that selectively opens or closes electrical paths to one or more of the variable capacitors ($C_{var1}...C_{var(2n-1)}$) under the control of one or more switch control signals ($s_1...s_{2n-1}$), wherein the number of variable capacitors ($C_{var1}...C_{var(2n-1)}$) that contribute to the total capacitance of the switchable variable capacitor arrangement (911) is controlled by states of the one or more switch control signals ($s_1...s_{2n-1}$); and

generating the one or more switch control signals ($s_1...s_{2n-1}$) as a function of a desired operating frequency so as to achieve a total variable capacitance that reduces loop gain variation of the phase-locked loop (900); and using a prescaler (915) to divide a frequency of the oscillator output signal by a predetermined amount to generate a prescaler output signal; and

using a frequency divider (917) to generate the feedback signal by dividing a frequency of the prescaler output signal by a predetermined amount; and

generating the one or more switch control signals ($s_1...s_{2n-1}$) so as to open and close appropriate sets of switches within the switch arrangement (201-1 ... 201-($2^n$-1)) so as to produce a desired controlled oscillator gain, $H_{CO}$, that will counteract variations in $H_{PS}H_{FD}$, such that the overall variation of the gain product $H_{CO}H_{PS}H_{FD}$ is reduced in a predefined frequency range, wherein $H_{PS}$ is a transfer function of the prescaler (915) and $H_{FD}$ is a transfer function of the frequency divider (917);

**characterised in that** the one or more switch control signals ($s_1...s_{2n-1}$) are generated by a binary-to-thermometer decoder (250).

## Patentansprüche

1.  Phasenregelkreis (900), umfassend:

    Logik (903), die konfiguriert ist, um ein Signal zu erzeugen, das eine Phasendifferenz zwischen einem Referenzsignal (901) und einem Rückkopplungssignal angibt, wobei eine Frequenz des Rückkopplungssignals von einer Frequenz eines Phasenregelkreis-Ausgabesignals abgeleitet ist; und
    einen gesteuerten Oszillator (909), der ein Oszillatorausgabesignal erzeugt, das eine Frequenz aufweist, die zumindest teilweise eine Funktion des erzeugten Signals ist,
    wobei der gesteuerte Oszillator (909) umfasst:

        eine schaltbare variable Kondensatoranordnung (911) zum Abstimmen einer Ausgabefrequenz des gesteuerten Oszillators (909); und
        Schaltung, die in Kombination mit der schaltbaren variablen Kondensatoranordnung (911) ein oszillierendes Signal erzeugt, dessen Frequenz zumindest teilweise eine Funktion einer Gesamtkapazität der schaltbaren variablen Kondensatoranordnung (911) ist;

    wobei die schaltbare variable Kondensatoranordnung (911) umfasst:

        eine Vielzahl von variablen Kondensatoren ($C_{var1}...C_{var(2n-1)}$), die jeweils mittels eines Abstimmsteuersignals ($v_{ctrl}$) abstimmbar sind; und
        eine Schaltanordnung (201-1 ... 201-($2^n$-1)), die selektiv elektrische Wege zu einem oder mehreren der variablen Kondensatoren ($C_{var1}...C_{var(2n-1)}$) unter der Steuerung eines oder mehrerer Schaltsteuersignale ($s_1...s_{2n-1}$) öffnet oder schließt, wobei die Anzahl der variablen Kondensatoren, die zur Gesamtkapazität der schaltbaren variablen Kondensatoranordnung (911) beitragen, durch Zustände der einen oder mehreren Schaltsteuersignale ($s_1...s_{2n-1}$) gesteuert wird,

    wobei der Phasenregelkreis (900) weiter umfasst:

        Schaltsteuerschaltung (913) zum Erzeugen der einen oder mehreren Schaltsteuersignale ($s_1...s_{2n-1}$) in Abhängigkeit von einer gewünschten Betriebsfrequenz, um eine Gesamtvariable Kapazität zu erreichen, die Kreisverstärkungsvariation des Phasenregelkreises (900) reduziert,
        wobei:
        der Phasenregelkreis (900) umfasst:

            einen Frequenzteiler (917), der das Rückkopplungssignal erzeugt, indem er eine Frequenz des Oszillatorausgabesignals durch einen vorbestimmten Betrag teilt; und
            die Schaltsteuerschaltung (913) das eine oder die mehreren Schaltsteuersignale ($s_1...s_{2n-1}$) erzeugt,

um geeignete Schaltsätze innerhalb der Schaltanordnung (201-1... 201-($2^n$-1)) zu öffnen und zu schließen, um eine gewünschte gesteuerte Oszillatorverstärkung, Hco, zu erzeugen, die Variationen in $H_{FD}$ entgegenwirkt, so dass die Gesamtvariation des Verstärkungsprodukts $H_{CO}H_{FD}$ in einem vorbestimmten Frequenzbereich reduziert wird, wobei $H_{FD}$ eine Übertragungsfunktion des Frequenzteilers (917) ist;

**dadurch gekennzeichnet, dass** das eine oder die mehreren Schaltsteuersignale ($s_1...s_{2n-1}$) von einem Binär-zu-Thermometer-Decoder (250) erzeugt werden.

2. Phasenregelkreis (900) nach Anspruch 1, wobei die Schaltsteuerschaltung (913) eine unterschiedliche Anzahl der variablen Kondensatoren ($C_{var1}...C_{var(2n-1)}$) in die schaltbare variable Kondensatoranordnung (911) für eine unterschiedliche gewünschte Betriebsfrequenz schaltet, so dass die Verstärkungsvariation des gesteuerten Oszillators (909) über ein ganzes Frequenzband reduziert wird.

3. Phasenregelkreis (900), umfassend:

Logik (913), die konfiguriert ist, um ein Signal zu erzeugen, das eine Phasendifferenz zwischen einem Referenzsignal (901) und einem Rückkopplungssignal angibt, wobei eine Frequenz des Rückkopplungssignals von einer Frequenz eines Phasenregelkreis-Ausgabesignals abgeleitet ist; und
einen gesteuerten Oszillator (909), der ein Oszillatorausgabesignal erzeugt, das eine Frequenz aufweist, die zumindest teilweise eine Funktion des erzeugten Signals ist,
wobei der gesteuerte Oszillator (909) umfasst:

eine schaltbare variable Kondensatoranordnung (911) zum Abstimmen einer Ausgabefrequenz des gesteuerten Oszillators (909); und
Schaltung, die in Kombination mit der schaltbaren variablen Kondensatoranordnung (911) ein oszillierendes Signal erzeugt, dessen Frequenz zumindest teilweise eine Funktion einer Gesamtkapazität der schaltbaren variablen Kondensatoranordnung (911) ist;

wobei die schaltbare variable Kondensatoranordnung (911) umfasst:

eine Vielzahl von variablen Kondensatoren ($C_{var1}...C_{var(2n-1)}$), die jeweils mittels eines Abstimmsteuersignals ($v_{ctrl}$) abstimmbar sind; und
eine Schaltanordnung (201-1 ... 201-($2^n$-1)), die selektiv elektrische Wege zu einem oder mehreren der variablen Kondensatoren ($C_{var1}...C_{var(2n-1)}$) unter der Steuerung eines oder mehrerer Schaltsteuersignale ($s_1...s_{2n-1}$) öffnet oder schließt, wobei die Anzahl der variablen Kondensatoren ($C_{var1}...C_{var(2n-1)}$), die zur Gesamtkapazität der schaltbaren variablen Kondensatoranordnung (911) beitragen, durch Zustände der einen oder mehreren Schaltsteuersignale ($s_1...s_{2n-1}$) gesteuert wird,

wobei der Phasenregelkreis (900) weiter umfasst:

Schaltsteuerschaltung (913) zum Erzeugen der einen oder mehreren Schaltsteuersignale ($s_1...s_{2n-1}$) in Abhängigkeit von einer gewünschten Betriebsfrequenz, um eine Gesamtvariable Kapazität zu erreichen, die Kreisverstärkungsvariation des Phasenregelkreises (900) reduziert,
wobei:
der Phasenregelkreis (900) umfasst:

einen Vorteiler (915), der eine Frequenz des Oszillatorausgabesignals durch einen vorbestimmten Betrag teilt, um ein Vorteilerausgabesignal zu erzeugen; und
einen Frequenzteiler (917), der das Rückkopplungssignal erzeugt, indem er eine Frequenz des Oszillatorausgabesignals durch einen vorbestimmten Betrag teilt; und

die Schaltsteuerschaltung (913) das eine oder die mehreren Schaltsteuersignale ($s_1...s_{2n-1}$) erzeugt, um geeignete Schaltsätze innerhalb der Schaltanordnung (201-1... 201-($2^n$-1)) zu öffnen und zu schließen, um eine gewünschte gesteuerte Oszillatorverstärkung, $H_{CO}$, zu erzeugen, die Variationen in $H_{PS}H_{FD}$ entgegenwirkt, so dass die Gesamtvariation des Verstärkungsprodukts $H_{CO}H_{PS}H_{FD}$ in einem vorbestimmten Frequenzbereich reduziert wird, wobei $H_{PS}$ eine Übertragungsfunktion des Vorteilers (915) ist und $H_{FD}$ eine Übertragungsfunktion des Frequenzteilers (917) ist;
**dadurch gekennzeichnet, dass** das eine oder die mehreren Schaltsteuersignale ($s_1...s_{2n-1}$) von einem

Binär-zu-Thermometer-Decoder (250) erzeugt werden.

4. Verfahren zum Erzeugen eines oszillierenden Signals, umfassend:

Erzeugen eines Signals, das eine Phasendifferenz zwischen einem Referenzsignal und einem Rückkopplungssignal angibt, wobei eine Frequenz des Rückkopplungssignals von einer Frequenz einer Phasenregelkreis-Signalausgabe abgeleitet ist;
Verwenden eines gesteuerten Oszillators (909) zum Erzeugen eines Oszillatorausgabesignals, das eine Frequenz aufweist, die zumindest teilweise eine Funktion des erzeugten Signals ist,
wobei der gesteuerte Oszillator (909) umfasst:

eine schaltbare variable Kondensatoranordnung (911) zum Abstimmen einer Ausgabefrequenz des gesteuerten Oszillators (909); und
Schaltung, die in Kombination mit der schaltbaren variablen Kondensatoranordnung (911) ein oszillierendes Signal erzeugt, dessen Frequenz zumindest teilweise eine Funktion einer Gesamtkapazität der schaltbaren variablen Kondensatoranordnung (911) ist,

wobei die schaltbare variable Kondensatoranordnung (911) umfasst:

eine Vielzahl von variablen Kondensatoren ($C_{var1}...C_{var(2n-1)}$), die jeweils mittels eines Abstimmsteuersignals ($v_{ctrl}$) abstimmbar sind;
eine Schaltanordnung ($201\text{-}1 ... 201\text{-}(2^n\text{-}1)$), die selektiv elektrische Wege zu einem oder mehreren der variablen Kondensatoren ($C_{var1}...C_{var(2n-1)}$) unter der Steuerung eines oder mehrerer Schaltsteuersignale ($s_i...s_{2n-1}$) öffnet oder schließt, wobei die Anzahl der variablen Kondensatoren, die zur Gesamtkapazität der schaltbaren variablen Kondensatoranordnung (911) beitragen, durch Zustände der einen oder mehreren Schaltsteuersignale ($s_1...s_{2n-1}$) gesteuert wird; und
Erzeugen der einen oder mehreren Schaltsteuersignale ($s_1...s_{2n-1}$) in Abhängigkeit von einer gewünschten Betriebsfrequenz, um eine Gesamtkapazität zu erreichen, die Kreisverstärkungsvariation des Phasenregelkreises (900) reduziert; und

Verwenden eines Frequenzteilers (917) zum Erzeugen des Rückkopplungssignals durch Teilen einer Frequenz des Oszillatorausgabesignals durch einen vorbestimmten Betrag; und
Erzeugen der einen oder mehreren Schaltsteuersignale ($s_1...s_{2n-1}$), um geeignete Schaltsätze innerhalb der Schaltanordnung ($201\text{-}1 ... 201\text{-}(2^n\text{-}1)$) zu öffnen und zu schließen, um eine gewünschte gesteuerte Oszillatorverstärkung, Hco, zu erzeugen, die Variationen in $H_{FD}$ entgegenwirkt, so dass die Gesamtvariation des Verstärkungsprodukts $H_{CO}H_{FD}$ in einem vorbestimmten Frequenzbereich reduziert wird, wobei $H_{FD}$ eine Übertragungsfunktion des Frequenzteilers (917) ist;
**dadurch gekennzeichnet, dass** das eine oder die mehreren Schaltsteuersignale ($s_1...s_{2n-1}$) von einem Binär-zu-Thermometer-Decoder (250) erzeugt werden.

5. Verfahren nach Anspruch 4, wobei das Erzeugen der einen oder mehreren Schaltsteuersignale ($s_1...s_{2n-1}$) das Schalten einer unterschiedlichen Anzahl der variablen Kondensatoren ($C_{var1}...C_{var(2n-1)}$) in die schaltbare variable Kondensatoranordnung (911) für eine unterschiedliche gewünschte Betriebsfrequenz umfasst, so dass die Verstärkungsvariation des gesteuerten Oszillators (909) über ein ganzes Frequenzband reduziert wird.

6. Verfahren zum Erzeugen eines oszillierenden Signals, umfassend:

Erzeugen eines Signals, das eine Phasendifferenz zwischen einem Referenzsignal (901) und einem Rückkopplungssignal angibt, wobei eine Frequenz des Rückkopplungssignals von einer Frequenz einer Phasenregelkreis-Signalausgabe abgeleitet ist;
Verwenden eines gesteuerten Oszillators (909) zum Erzeugen eines Oszillatorausgabesignals, das eine Frequenz aufweist, die zumindest teilweise eine Funktion des erzeugten Signals ist,
wobei der gesteuerte Oszillator (909) umfasst:

eine schaltbare variable Kondensatoranordnung (911) zum Abstimmen einer Ausgabefrequenz des gesteuerten Oszillators; und
Schaltung, die in Kombination mit der schaltbaren variablen Kondensatoranordnung (911) ein oszillierendes Signal erzeugt, dessen Frequenz zumindest teilweise eine Funktion einer Gesamtkapazität der schaltbaren variablen Kondensatoranordnung (911) ist,

wobei die schaltbare variable Kondensatoranordnung (911) umfasst:

eine Vielzahl von variablen Kondensatoren ($C_{var1}...C_{var(2n-1)}$), die jeweils mittels eines Abstimmsteuersignals ($v_{ctrl}$) abstimmbar sind;
eine Schaltanordnung ($201\text{-}1 ... 201\text{-}(2^n\text{-}1)$), die selektiv elektrische Wege zu einem oder mehreren der variablen Kondensatoren ($C_{var1}...C_{var(2n-1)}$) unter der Steuerung eines oder mehrerer Schaltsteuersignale ($s_1...s_{2n-1}$) öffnet oder schließt, wobei die Anzahl der variablen Kondensatoren ($C_{var1}...C_{var(2n-1)}$), die zur Gesamtkapazität der schaltbaren variablen Kondensatoranordnung (911) beitragen, durch Zustände der einen oder mehreren Schaltsteuersignale ($s_1...s_{2n-1}$) gesteuert wird; und
Erzeugen der einen oder mehreren Schaltsteuersignale ($s_1...s_{2n-1}$) in Abhängigkeit von einer gewünschten Betriebsfrequenz, um eine Gesamtkapazität zu erreichen, die Kreisverstärkungsvariation des Phasenregelkreises (900) reduziert; und

Verwenden eines Vorteilers (915) zum Teilen einer Frequenz des Oszillatorausgabesignals durch einen vorbestimmten Betrag, um ein Vorteilerausgabesignal zu erzeugen; und
Verwenden eines Frequenzteilers (917) zum Erzeugen des Rückkopplungssignals durch Teilen einer Frequenz des Vorteilerausgabesignals durch einen vorbestimmten Betrag; und
Erzeugen der einen oder mehreren Schaltsteuersignale ($s_1...s_{2n-1}$), um geeignete Schaltsätze innerhalb der Schaltanordnung ($201\text{-}1 ... 201\text{-}(2^n\text{-}1)$) zu öffnen und zu schließen, um eine gewünschte gesteuerte Oszillatorverstärkung, Hco, zu erzeugen, die Variationen in $H_{PS}H_{FD}$ entgegenwirkt, so dass die Gesamtvariation des Verstärkungsprodukts $H_{CO}H_{PS}H_{FD}$ in einem vorbestimmten Frequenzbereich reduziert wird, wobei $H_{PS}$ eine Übertragungsfunktion des Vorteilers (915) ist und $H_{FD}$ eine Übertragungsfunktion des Frequenzteilers (917) ist; **dadurch gekennzeichnet, dass** das eine oder die mehreren Schaltsteuersignale ($s_1...s_{2n-1}$) von einem Binär-zu-Thermometer-Decoder (250) erzeugt werden.

## Revendications

1.  Boucle à phase asservie (900) comprenant :

une logique (903) configurée pour générer un signal qui indique une différence de phase entre un signal de référence (901) et un signal de rétroaction, dans laquelle une fréquence du signal de rétroaction est dérivée d'une fréquence d'un signal de sortie de la boucle à phase asservie ; et
un oscillateur commandé (909) qui génère un signal de sortie d'oscillateur ayant une fréquence qui est, au moins en partie, fonction du signal généré,
dans laquelle l'oscillateur commandé (909) comprend :

un agencement de condensateurs variables commutables (911) permettant d'accorder une fréquence de sortie de l'oscillateur commandé (909) ; et
un circuit qui, en combinaison avec l'agencement de condensateurs variables commutables (911), génère un signal oscillant dont la fréquence est, au moins en partie, fonction d'une capacité totale de l'agencement de condensateurs variables commutables (911) ;

dans laquelle l'agencement de condensateurs variables commutables (911) comprend :

une pluralité de condensateurs variables ($C_{var1}...C_{var(2n-1)}$), chacun étant accordable au moyen d'un signal de commande d'accord ($v_{ctrl}$) ; et
un agencement de commutateurs ($201\text{-}1 ... 201\text{-}(2^n\text{-}1)$) qui ouvre ou ferme sélectivement des trajets électriques menant à un ou plusieurs des condensateurs variables ($C_{var1}...C_{var(2n-1)}$) sous la commande d'un ou plusieurs signaux de commande de commutateur ($s_1...s_{2n-1}$), dans laquelle le nombre de condensateurs variables qui contribuent à la capacité totale de l'agencement de condensateurs variables commutables (911) est commandé par des états des un ou plusieurs signaux de commande de commutateur ($s_1...s_{2n-1}$),

dans laquelle la boucle à phase asservie (900) comprend en outre :

un circuit de commande de commutateur (913) permettant de générer les un ou plusieurs signaux de

commande de commutateur ($s_1...s_{2n-1}$) en fonction d'une fréquence de fonctionnement souhaitée de manière à obtenir une capacité variable totale qui réduise une variation du gain de boucle de la boucle à phase asservie (900),

dans laquelle :

la boucle à phase asservie (900) comprend :

un diviseur de fréquence (917) qui génère le signal de rétroaction en divisant une fréquence du signal de sortie de l'oscillateur par une quantité prédéterminée ; et

le circuit de commande de commutateur (913) génère les un ou plusieurs signaux de commande de commutateur ($s_1...s_{2n-1}$) de manière à ouvrir et fermer des ensembles de commutateurs appropriés au sein de l'agencement de commutateurs (201-1 ... 201-($2^n$-1)) de manière à produire un gain souhaité de l'oscillateur commandé, Hco, qui compense des variations de $H_{FD}$, de sorte que la variation globale du produit de gain $H_{CO}H_{FD}$ soit réduite dans une plage de fréquence prédéfinie, dans laquelle $H_{FD}$ est une fonction de transfert du diviseur de fréquence (917) ;

**caractérisée en ce que** les un ou plusieurs signaux de commande de commutateur ($s_1...s_{2n-1}$) sont générés par un décodeur binaire-thermométrique (250).

2. Boucle à phase asservie (900) selon la revendication 1, dans laquelle le circuit de commande de commutateur (913) commute un nombre différent des condensateurs variables ($C_{var1}...C_{var(2n-1)}$) dans l'agencement de condensateurs variables commutables (911) pour une fréquence de fonctionnement souhaitée différente de sorte que la variation de gain de l'oscillateur commandé (909) sur la totalité d'une bande de fréquence soit réduite.

3. Boucle à phase asservie (900) comprenant :

une logique (913) configurée pour générer un signal qui indique une différence de phase entre un signal de référence (901) et un signal de rétroaction, dans laquelle une fréquence du signal de rétroaction est dérivée d'une fréquence d'un signal de sortie de la boucle à phase asservie ; et

un oscillateur commandé (909) qui génère un signal de sortie d'oscillateur ayant une fréquence qui est, au moins en partie, fonction du signal généré,

dans laquelle l'oscillateur commandé (909) comprend :

un agencement de condensateurs variables commutables (911) permettant d'accorder une fréquence de sortie de l'oscillateur commandé (909) ; et

un circuit qui, en combinaison avec l'agencement de condensateurs variables commutables (911), génère un signal oscillant dont la fréquence est, au moins en partie, fonction d'une capacité totale de l'agencement de condensateurs variables commutables (911) ;

dans laquelle l'agencement de condensateurs variables commutables (911) comprend :

une pluralité de condensateurs variables ($C_{var1}...C_{var(2n-1)}$), chacun étant accordable au moyen d'un signal de commande d'accord ($v_{ctrl}$) ; et

un agencement de commutateurs (201-1 ... 201-($2^n$-1)) qui ouvre ou ferme sélectivement des trajets électriques menant à un ou plusieurs des condensateurs variables ($C_{var1}...C_{var(2n-1)}$) sous la commande d'un ou plusieurs signaux de commande de commutateur ($s_1...s_{2n-1}$), dans laquelle le nombre de condensateurs variables ($C_{var1}...C_{var(2n-1)}$) qui contribuent à la capacité totale de l'agencement de condensateurs variables commutables (911) est commandé par des états des un ou plusieurs signaux de commande de commutateur ($s_1...s_{2n-1}$),

dans laquelle la boucle à phase asservie (900) comprend en outre :

un circuit de commande de commutateur (913) permettant de générer les un ou plusieurs signaux de commande de commutateur ($s_1...s_{2n-1}$) en fonction d'une fréquence de fonctionnement souhaitée de manière à obtenir une capacité variable totale qui réduise une variation de gain de boucle de la boucle à phase asservie (900),

dans laquelle :

la boucle à phase asservie (900) comprend :

un prédiviseur (915) qui divise une fréquence du signal de sortie de l'oscillateur par une quantité prédéterminée pour générer un signal de sortie de prédiviseur ; et

un diviseur de fréquence (917) qui génère le signal de rétroaction en divisant une fréquence du signal de sortie de l'oscillateur par une quantité prédéterminée ; et

le circuit de commande de commutateur (913) génère les un ou plusieurs signaux de commande de commutateur ($s_1...s_{2n-1}$) de manière à ouvrir et fermer des ensembles de commutateurs appropriés au sein de l'agencement de commutateurs (201-1 ... 201-($2^n$-1)) de manière à produire un gain souhaité de l'oscillateur commandé, $H_{CO}$, qui compense des variations de $H_{PS}H_{FD}$, de sorte que la variation globale du produit de gain $H_{CO}H_{PS}H_{FD}$ soit réduite dans une plage de fréquence prédéfinie, dans laquelle $H_{PS}$ est une fonction de transfert du prédiviseur (915) et $H_{FD}$ est une fonction de transfert du diviseur de fréquence (917) ;

**caractérisée en ce que** les un ou plusieurs signaux de commande de commutateur ($s_1...s_{2n-1}$) sont générés par un décodeur binaire-thermométrique (250).

4. Procédé de génération d'un signal oscillant comprenant :

la génération d'un signal qui indique une différence de phase entre un signal de référence et un signal de rétroaction, dans lequel une fréquence du signal de rétroaction est dérivée d'une fréquence d'un signal de sortie de la boucle à phase asservie ;

l'utilisation d'un oscillateur commandé (909) pour générer un signal de sortie d'oscillateur ayant une fréquence qui est, au moins en partie, fonction du signal généré,

dans lequel l'oscillateur commandé (909) comprend :

un agencement de condensateurs variables commutables (911) permettant d'accorder une fréquence de sortie de l'oscillateur commandé (909) ; et

un circuit qui, en combinaison avec l'agencement de condensateurs variables commutables (911), génère un signal oscillant dont la fréquence est, au moins en partie, fonction d'une capacité totale de l'agencement de condensateurs variables commutables (911),

dans lequel l'agencement de condensateurs variables commutables (911) comprend :

une pluralité de condensateurs variables ($C_{var1}...C_{var(2n-1)}$), chacun étant accordable au moyen d'un signal de commande d'accord ($v_{ctrl}$) ;

un agencement de commutateurs (201-1 ... 201-($2^n$-1)) qui ouvre ou ferme sélectivement des trajets électriques menant à un ou plusieurs des condensateurs variables ($C_{var1}...C_{var(2n-1)}$) sous la commande d'un ou plusieurs signaux de commande de commutateur ($s_i...s_{2,1}$), dans lequel le nombre de condensateurs variables qui contribuent à la capacité totale de l'agencement de condensateurs variables commutables (911) est commandé par des états des un ou plusieurs signaux de commande de commutateur ($s_1...s_{2n-1}$); et

la génération des un ou plusieurs signaux de commande de commutateur ($s_1...s_{2n-1}$) en fonction d'une fréquence de fonctionnement souhaitée de manière à obtenir une capacité variable totale qui réduise une variation de gain de boucle de la boucle à phase asservie (900) ; et

l'utilisation d'un diviseur de fréquence (917) pour générer le signal de rétroaction en divisant une fréquence du signal de sortie de l'oscillateur par une quantité prédéterminée ; et

la génération des un ou plusieurs signaux de commande de commutateur ($s_1...s_{2n-1}$) de manière à ouvrir et fermer des ensembles de commutateurs appropriés au sein de l'agencement de commutateurs (201-1 ... 201-($2^n$-1)) de manière à produire un gain souhaité de l'oscillateur commandé, Hco, qui compense des variations de $H_{FD}$, de sorte que la variation globale du produit de gain $H_{CO}H_{FD}$ soit réduite dans une plage de fréquence prédéfinie, dans lequel $H_{FD}$ est une fonction de transfert du diviseur de fréquence (917) ;

**caractérisé en ce que** les un ou plusieurs signaux de commande de commutateur ($s_1...s_{2n-1}$) sont générés par un décodeur binaire-thermométrique (250).

5. Procédé selon la revendication 4, dans lequel la génération des un ou plusieurs signaux de commande de commutateur ($s_1...s_{2n-1}$) comprend la commutation d'un nombre différent des condensateurs variables ($C_{var1}...C_{var(2n-1)}$) dans l'agencement de condensateurs variables commutables (911) pour une fréquence de fonctionnement souhaitée différente de sorte que la variation de gain de l'oscillateur commandé (909) sur la totalité d'une bande de fréquence soit réduite.

**6.** Procédé de génération d'un signal oscillant comprenant :

la génération d'un signal qui indique une différence de phase entre un signal de référence (901) et un signal de rétroaction, dans lequel une fréquence du signal de rétroaction est dérivée d'une fréquence d'un signal de sortie de la boucle à phase asservie ;
l'utilisation d'un oscillateur commandé (909) pour générer un signal de sortie d'oscillateur ayant une fréquence qui est, au moins en partie, fonction du signal généré,
dans lequel l'oscillateur commandé (909) comprend :

un agencement de condensateurs variables commutables (911) permettant d'accorder une fréquence de sortie de l'oscillateur commandé ; et
un circuit qui, en combinaison avec l'agencement de condensateurs variables commutables (911), génère un signal oscillant dont la fréquence est, au moins en partie, fonction d'une capacité totale de l'agencement de condensateurs variables commutables (911),

dans lequel l'agencement de condensateurs variables commutables (911) comprend :

une pluralité de condensateurs variables ($C_{var1}...C_{var(2n-1)}$), chacun étant accordable au moyen d'un signal de commande d'accord ($v_{ctrl}$) ;
un agencement de commutateurs ($201\text{-}1 ... 201\text{-}(2^n\text{-}1)$) qui ouvre ou ferme sélectivement des trajets électriques menant à un ou plusieurs des condensateurs variables ($C_{var1}...C_{var(2n-1)}$) sous la commande d'un ou plusieurs signaux de commande de commutateur ($s_1...s_{2n-1}$), dans lequel le nombre de condensateurs variables ($C_{var1}...C_{var(2n-1)}$) qui contribuent à la capacité totale de l'agencement de condensateurs variables commutables (911) est commandé par des états des un ou plusieurs signaux de commande de commutateur ($s_1...s_{2n-1}$); et
la génération des un ou plusieurs signaux de commande de commutateur ($s_1...s_{2n-1}$) en fonction d'une fréquence de fonctionnement souhaitée de manière à obtenir une capacité variable totale qui réduise une variation de gain de boucle de la boucle à phase asservie (900) ; et

l'utilisation d'un prédiviseur (915) pour diviser une fréquence du signal de sortie de l'oscillateur par une quantité prédéterminée pour générer un signal de sortie de prédiviseur ; et
l'utilisation d'un diviseur de fréquence (917) pour générer le signal de rétroaction en divisant une fréquence du signal de sortie du prédiviseur par une quantité prédéterminée ; et
la génération des un ou plusieurs signaux de commande de commutateur ($s_1...s_{2n-1}$) de manière à ouvrir et fermer des ensembles de commutateurs appropriés au sein de l'agencement de commutateurs ($201\text{-}1 ... 201\text{-}(2^n\text{-}1)$) de manière à produire un gain souhaité de l'oscillateur commandé, $H_{CO}$, qui compense des variations de $H_{PS}H_{FD}$, de sorte que la variation globale du produit de gain $H_{CO}H_{PS}H_{FD}$ soit réduite dans une plage de fréquence prédéfinie, dans lequel $H_{PS}$ est une fonction de transfert du prédiviseur (915) et $H_{FD}$ est une fonction de transfert du diviseur de fréquence (917) ;
**caractérisé en ce que** les un ou plusieurs signaux de commande de commutateur ($s_1...s_{2n-1}$) sont générés par un décodeur binaire-thermométrique (250).

100

$v_{pos}$

L

$C_{dis}$

$v_{neg}$

$v_{ctrl}$

$C_{var}$

$I_{vco}$

FIG. 1

FIG. 2A

FIG. 2B

FIG. 3

FIG. 4

FIG. 5

FIG. 6

**FIG. 7A**

**FIG. 7B**

**FIG. 8**

FIG. 9

EP 1 982 410 B1

**REFERENCES CITED IN THE DESCRIPTION**

**Patent documents cited in the description**

- US 20030231068 A1
- US 20040263272 A1
- US 2005275478 A